# FASCICULE DE BREVET EUROPEEN

(11) **EP 0 448 426 B1**
(45) Date de publication et mention de la délivrance du brevet: **18.01.1995**
(21) Numéro de dépôt: 91400462.7
(22) Date de dépôt: 20.02.1991
(51) Int. Cl.: C09D 5/32, H05K 9/00

(54) **Enduit absorbant, son procédé de fabrication et revêtement obtenu à l'aide de cet enduit**
Absorbierende Überzugszusammensetzung, Verfahren zur Herstellung und Verkleidung daraus
Absorbant coating composition, preparation thereof and cladding obtained therefrom

(30) Priorité: 22.02.1990 FR 9002194
(43) Date de publication de la demande: 25.09.1991
(73) Titulaire: COMMISSARIAT A L'ENERGIE ATOMIQUE, 75015 Paris (FR)
(72) Inventeur: Kumurdjian, Pierre, F-91530 Saint Cheron (FR)
(74) Mandataire: Signore, Robert

(56) Documents cités:
- EP-A- 0 308 334
- US-A- 4 608 297
- PATENT ABSTRACTS OF JAPAN, vol. 5, no. 3 (E-40)(675), 10 janvier 1981; & JP-A-55 133 507

## Description

La présente invention a pour objet un enduit absorbant, son procédé de fabrication et un revêtement obtenu à l'aide de cet enduit.

Dans le brevet français FR-A-2 655 997 Brevet américain US-A-5 148 172, il est décrit et revendiqué un enduit absorbant, qui est caractérisé par le fait qu'il comprend un liant et une charge constituée de copeaux constitués d'au moins une couche mince apte à absorber un rayonnement électromagnétique.

Lorsqu'il s'agit d'absorber un rayonnement qui tombe dans la plage des micro-ondes, chaque copeau est constitué d'un empilement de couches alternativement magnétiques amorphes et électriquement isolantes.

De préférence, le matériau magnétique amorphe est un matériau ferromagnétique à forte perméabilité magnétique.

Les couches magnétiques peuvent avoir une épaisseur comprise entre 100 et 1000 nm.

Les couches isolantes peuvent avoir une épaisseur comprise entre 1 et 200 nm.

Dans le cas de l'absorption d'une onde électromagnétique hyperfréquence, c'est-à-dire dans la gamme allant de 50 MHz à plusieurs dizaines de Gigahertz, le copeau peut être d'une structure particulière, qui est l'objet de la présente invention. Afin de permettre la propagation de l'onde électromagnétique dans l'enduit avec un taux de réflexion faible, les copeaux devraient être électriquement isolés dans le liant. Pour se libérer de cette contrainte et des aspects dimensionnels du copeau vis-à-vis de la fréquence, on peut fabriquer un copeau à l'aide d'un matériau amorphe de forte résistivité. On s'affranchit alors des impératifs dimensionnels relatifs aux copeaux.

Une couche magnétique amorphe de forte résistivité peut être obtenue en utilisant un matériau magnétique amorphe en couche ultramince de 3 nm d'épaisseur ou moins ; ce type de couche ultramince présente une perméabilité très élevée, plus élevée que celle des couches minces classiques d'épaisseur supérieure à 100 nm. On superpose alors à cette couche magnétique une couche ultramince d'isolant, de 5 nm d'épaisseur. On redépose ensuite une couche ultramince magnétique, etc. On obtient ainsi ce qu'on peut appeler un "sous-empilement" (par opposition à l'empilement principal) formé de centaines ou plus de couches ultraminces. Le composite ainsi obtenu jouera le rôle de couche mince magnétique au sens du brevet déjà cité.

Il est également possible d'avoir une très forte épaisseur de couches ultraminces, puisque la résistivité de ce composite est suffisamment élevée pour qu'on puisse se passer des couches d'isolant "épais". Le sous-empilement de couches ultraminces constitue alors à lui seul la couche mince absorbante.

La résistivité du composite doit être supérieure à quelques Ohms-cm (5 par exemple). Des couches ultraminces d'alliage de cobalt avec de la silice ont fait gagner un facteur 10 sur la résistivité de l'alliage seul. Le gain en résistivité supplémentaire sera obtenu par un compromis judicieux entre l'épaisseur de l'alliage et celle de l'isolant.

Il est également possible d'utiliser d'autres isolants, par exemple le carbone (en dépôt très fin et uniforme) ou des matériaux organiques. Il est aussi possible d'utiliser des artifices de dépôt (inclinaison du substrat, rugosité).

On peut enfin déposer simultanément les matériaux magnétique et isolant si les couches obtenues sont formées en microdomaines magnétiques et isolants séparés, conduisant dès lors à une structure équivalente au sous-empilement alterné de couches ultraminces.

De façon précise, la présente invention a pour objet un enduit absorbant comprenant un liant et une charge constituée de copeaux aptes à absorber un rayonnement électromagnétique, caractérisé par le fait que chaque copeau comprend au moins un sous-empilement de couches magnétiques amorphes ultraminces et de couches isolantes ultraminces.

Dans une première variante, chaque copeau comprend un empilement de couches constituées alternativement dudit sous-empilement de couches et de couches électriquement isolantes.

Dans une seconde variante, chaque copeau comprend uniquement ledit sous-empilement.

La présente invention a également pour objet un procédé de fabrication d'un enduit absorbant, comprenant les opérations suivantes :
- on dépose sous vide, sur un substrat, un empilement apte à absorber un rayonnement électromagnétique,
- on brise cet empilement pour le réduire en copeaux,
- on mélange ces copeaux à un liant,
ce procédé étant caractérisé par le fait que, pour déposer sur le substrat ledit empilement, on dépose au moins un sous-empilement de couches magnétiques amorphes ultraminces et de couches isolantes ultraminces.

Dans une première variante, on dépose sur le substrat alternativement ledit sous-empilement et des couches électriquement isolantes.

Dans une seconde variante, on dépose sur le substrat uniquement ledit sous-empilement.

Enfin, la présente invention a pour objet un revêtement absorbant caractérisé par le fait qu'il comprend au moins une couche d'enduit tel qu'il vient d'être défini.

De toute façon, les caractéristiques et avantages de l'invention apparaîtront mieux à la lumière de la description qui suit. Cette description porte sur des exemples de réalisation donnés à titre explicatif et nullement limitatif et se réfère à des dessins annexés sur lesquels :
- la figure 1 montre le sous-empilement de couches ultraminces constituant chaque couche magnétique mince ;
- la figure 2 montre un empilement de couches ultraminces sur un substrat.

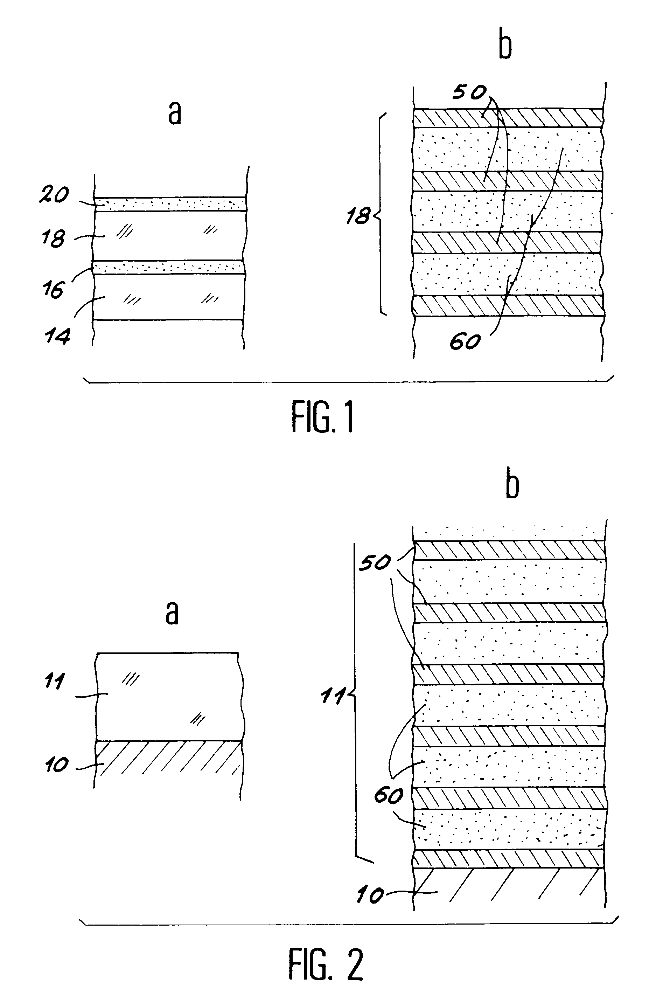

Sur la figure 1, on voit, sur la partie (a), une structure avec une alternance de couches magnétiques amorphes 14, 18 et de couches isolantes 16, 20. Selon une première variante de l'invention, chaque couche magnétique amorphe telle que 18 est formée d'un sous-empilement de couches magnétiques amorphes 50 et de couches isolantes 60.

Sur la figure 2, on voit la seconde variante dans laquelle la couche unique 11 déposée sur le substrat 10 (partie a) est constituée dans sa totalité d'un sous-empilement de couches ultraminces alternativement magnétiques 50 et isolantes 60.

Les couches magnétiques amorphes ultraminces 50 peuvent avoir une épaisseur de 3 nm.

Les couches isolantes ultraminces 60 peuvent avoir une épaisseur de 5 nm.

L'isolant peut être du carbone ou un matériau organique.

## Revendications

1. Enduit absorbant comprenant un liant et une charge constituée de copeaux aptes à absorber un rayonnement électromagnétique, caractérisé par le fait que chaque copeau comprend au moins un sous-empilement de couches magnétiques amorphes ultraminces (50) et de couches isolantes ultraminces (60), les couches magnétiques amorphes ultraminces (50) ayant une épaisseur de 3 nm ou moins, les couches isolantes ultraminces (60) ayant une épaisseur de 5 nm ou moins.

2. Enduit absorbant selon la revendication 1, caractérisé par le fait que chaque copeau comprend un empilement de couches constituées alternativement dudit sous-empilement (14, 18) et de couches électriquement isolantes (16, 20).

3. Enduit absorbant selon la revendication 1, caractérisé par le fait que chaque copeau comprend uniquement ledit sous-empilement (11).

4. Enduit selon l'une quelconque des revendications 1 à 3, caractérisé par le fait que l'isolant est du carbone.

5. Enduit selon l'une quelconque des revendications 1 à 3, caractérisé par le fait que l'isolant est un matériau organique.

6. Procédé de fabrication d'un enduit absorbant selon la revendication 1, comprenant les opérations suivantes :
- on dépose sous vide, sur un substrat (10), un empilement apte à absorber un rayonnement électromagnétique,
- on brise cet empilement pour le réduire en copeaux,
- on mélange ces copeaux à un liant,
ce procédé étant caractérisé par le fait que, pour déposer sur le substrat ledit empilement, on dépose au moins un sous-empilement de couches magnétiques amorphes ultraminces (50) et de couches isolantes ultraminces (60), les couches magnétiques amorphes ultraminces (50) étant déposées sur une épaisseur de 3 nm ou moins, les couches ultraminces (60) étant déposées sur une épaisseur de 5 nm ou moins.

7. Procédé selon la revendication 6, caractérisé par le fait qu'on dépose sur le substrat alternativement ledit sous-empilement et des couches électriquement isolantes.

8. Procédé selon la revendication 6, caractérisé par le fait qu'on dépose sur le substrat uniquement ledit sous-empilement.

9. Revêtement absorbant caractérisé par le fait qu'il comprend au moins une couche d'enduit selon l'une quelconque des revendications 1 à 5.

## Claims

1. Absorbent layer incorporating a binder and a charge constituted by chips able to absorb electromagnetic radiation, characterized in that each chip comprises at least one substack of ultra-thin amorphous magnetic films (50) and ultra-thin insulating films (60), the ultra-thin amorphous magnetic films (50) having a thickness of 3 nm or less and the ultra-thin insulating films (60) having a thickness of 5 nm or less.

2. Absorbent layer according to claim 1, characterized in that each chip comprises a stack of coatings constituted alternately by the said substack (14, 18) and electrically insulated coatings (16, 20).

3. Absorbent layer according to claim 1, characterized in that each chip solely comprises the said substack (11).

4. Layer according to any one of the claims 1 to 3, characterized in that the insulant is carbon.

5. Layer according to any one of the claims 1 to 3, characterized in that the insulant is an organic material.

6. Process for the production of an absorbent layer according to claim 1 comprising the following operations:
- the vacuum deposition on a substrate (10) of a stack able to absorb electromagnetic radiation,
- the breaking up of said stack to reduce it to chips,
- the mixing of said chips with a binder,
said process being characterized in that, for depositing the said stack on the substrate, deposition takes place of at least one substack of ultra-thin amorphous magnetic films (50) and ultra-thin insulating films (60), the ultra-thin amorphous magnetic films (50) being deposited over a thickness of 3 nm or less and the ultra-thin films (60) being deposited over a thickness of 5 nm or less.

7. Process according to claim 6, characterized in that deposition takes place on the substrate in alternating manner of said substack and the electrically insulating films.

8. Process according to claim 6, characterized in that only said substack is deposited on the substrate.

9. Absorbent covering, characterized in that it comprises at least one layer coating according to any one of the claims 1 to 5.

## Patentansprüche

1. Absorbierende Überzugszusammensetzung, ein Bindemittel enthalten und ein Füllmaterial, gebildet aus Spänen, die eine elektromagnetische Strahlung absorbieren können,
**dadurch gekennzeichnet**, daß jeder Span wenigstens einen Teilstapel aus ultradünnen amorphen magnetischen Schichten (50) und ultradünnen isolierenden Schichten (60) umfaßt, wobei die ultradünnen amorphen magnetischen Schichten (50) eine Dicke von 3 nm oder weniger haben und die ultradünnen isolierenden Schichten (60) eine Dicke von 5 nm oder weniger.

2. Absorbierende Überzugszusammensetzung nach Anspruch 1, dadurch gekennzeichnet, daß jeder Span einen Stapel von Schichten umfaßt, die wechselweise gebildet werden durch den besagten Teilstapel (14, 18) und durch elektrisch isolierende Schichten (16, 20).

3. Absorbierende Überzugszusammensetzung nach Anspruch 1, dadurch gekennzeichnet, daß jeder Span nur den besagten Teilstapel (11) aufweist.

4. Überzugszusammensetzung nach einem der Ansprüche 1 bis 3, dadurch gekennzeichnet, daß der Isolator Kohlenstoff ist.

5. Überzugszusammensetzung nach einem der Ansprüche 1 bis 3, dadurch gekennzeichnet, daß der Isolator ein organisches Material ist.

6. Herstellungsverfahren einer absorbierenden Überzugszusammensetzung nach Anspruch 1, das folgende Schritte umfaßt:
- Abscheiden, unter Vakuum auf einem Substrat (10), eines Stapels, geeignet zur Absorbierung von elektromagnecischer Strahlung,
- Brechen dieses Stapels, um ihn zu Spänen zu zerkleinern,
- Mischen dieser Späne mit einem Bindemittel,
dabei ist dieses Verfahren dadurch gekennzeichnet, daß man, um auf dem Substrat den besagten Stapel abzuscheiden, wenigstens einen Teilstapel aus ultradünnen amorphen magnetischen Schichten (50) und ultradünnen isolierenden Schichten (60) abscheidet, wobei die ultradünnen amorphen magnetischen Schichten (50) auf eine Dicke von 3 nm oder weniger abgeschieden werden und die ultradünnen Schichten (60) auf eine Dicke von 5 nm oder weniger.

7. Verfahren nach Anspruch 6, dadurch gekennzeichnet, daß man auf dem Substrat wechselweise den genannten Teilstapel und elektrisch isolierende Schichten abscheidet.

8. Verfahren nach Anspruch 6, dadurch gekennzeichnet, daß man auf dem Substrat nur den genannten Teilstapel abscheidet.

9. Absorbierender Überzug, dadurch gekennzeichnet, daß er wenigstens eine Schicht der absorbierenden Überzugszusammensetzung nach einem der Ansprüche 1 bis 5 enthält.
